# EUROPEAN PATENT SPECIFICATION

(11) **EP 0 392 631 B1**
(45) Date of publication and mention of the grant of the patent: **12.10.1994**
(21) Application number: 90200883.8
(22) Date of filing: 10.04.1990
(51) Int. Cl.: H04B 5/04, H05K 5/02, G08B 3/10, H05K 5/00

(54) **Housing for a paging receiver**
Gehäuse für einen Ausrufempfänger
Boîtier pour récepteur d'appel

(30) Priority: 11.04.1989 NL 8900903
(43) Date of publication of application: 17.10.1990
(73) Proprietor: ERICSSON RADIO SYSTEMS B.V., 7814 VA Emmen (NL)
(72) Inventor: Schuurmans, Johan Herman, NL-7854 RP Aalden (NL)
(74) Representative: van der Arend, Adrianus G.A., Ir.

(56) References cited:
- EP-A- 0 246 088
- WO-A-81/00654
- DE-U- 6 940 950
- DE-U- 8 003 837
- DE-U- 8 507 379
- US-A- 4 791 527

## Description

The invention relates to a paging receiver of a paging system, comprising a housing in which a number of electronic components are fitted on a printed circuit board fixed to the housing.

Such a paging receiver is known from WO-A-8 100 654.

In the field of paging systems it is desirable for a paging receiver to be as small and as light as possible, so that a user can carry the receiver easily without finding it inconvenient.

The object of the invention is therefore to provide an improved paging receiver which meets this requirement.

This object is achieved according to the invention for a paging receiver of the type mentioned in the preamble in that the printed circuit board is provided only at one side with components which are of great heights relative to the thickness of the board, and in that the board forms a wall part of the housing, while the side of the board without relatively high components forms a part of the outside of the housing. The thickness thereof relative to the remainder of the receiver is thereby limited, particularly if surface-mounted devices (SMDs) are used.

A thin decorative film can be placed on the outside of the printed circuit board, thus flattening out any unevennesses on the outside of the board. The board can then also be provided with printed conductors on the outside, in which case the film also prevents damage to these conductors.

The board can form an entire wall, for example the rear wall, or a part thereof, of the receiver.

The invention is explained with reference to the drawings. In the drawings:
Fig. 1 shows schematically in perspective, and disassembled, an embodiment of a paging receiver according to the invention; and
Figs. 2a to 2f show cross-sections of alternative embodiments of a paging receiver according to the invention.

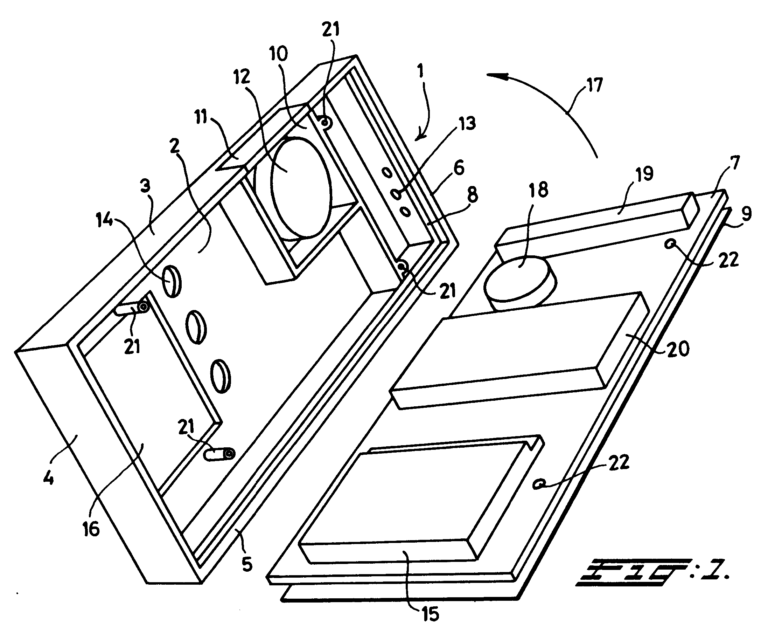

The paging receiver according to the invention shown schematically and partially provided with components in Fig. 1 comprises a housing with a main part 1, comprising a front wall 2 and side walls 3, 4, 5, 6 going out from it, and a closing part 7 which is formed by a printed circuit board 7, which is placed on a lowered edge 8 of the side walls, and on the outside of which a finishing layer or a decorative sheet 9 is provided.

The main part 1 has a space 10 into which a slide 11, on which there is a battery or chargeable accumulator 12, can be slid.

In the side wall 6 there are a number of passages, such as 13, behind which a connecting element (not shown) is fitted inside the housing for charging the accumulator 12 and/or programming the receiver if it is in a charging rack.

In the front wall 2 are a number of passages, such as 14, which are suitable for allowing through a control button which at the inside of the housing has a greater diameter than the diameter of the passage 14. Opposite such buttons, the board 7 is provided with a display unit 15, of which a raised screen part is accommodated in a recess 16 of the front wall 2 when the board 7 is turned in the direction of the arrow 17 and is placed on the edge 8 of the side walls 3 to 6. The buttons inserted through the passages 14 act on switch contacts (not shown) on an opposite part of the board 7. A resilient element with a number of conducting tracks between which the buttons can make a connection when depressed can also be provided between these buttons and the reproduction unit 15, or the board 7.

The board 7 is also provided with a signalling member 18, an aerial 19 and a number of electronic components, in particular components suitable for surface-mounting (SMDs), which are indicated by a single block 20 in Fig. 1.

A number of screw accommodation elements 21 with a central bore are formed on the inside of the front wall 2 of the main part 1. When the board 7 is placed on the edge 8 of the main part 1, the bores of the accommodation elements 21 are located opposite passages 22 formed in the board 7, which are each suitable for allowing through a screw which can be turned in an opposite bore.

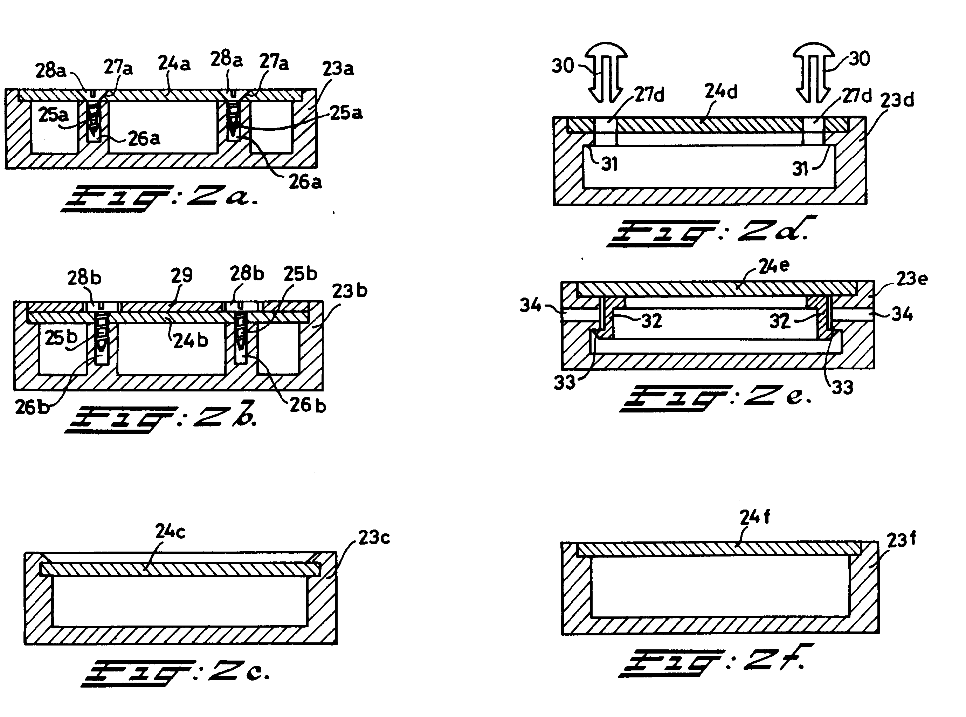

Figs. 2a to 2f show in cross-section six embodiments of a housing for a paging receiver according to the invention. Elements with the same function in different figures are provided with the letter of the relevant figure. In accordance with this, the figures show a main part 23a to 23f and a printed circuit board 24a to 24f of a housing of a paging receiver.

The embodiment of Fig. 2a has screw accommodation elements 25a each with a central bore 26a. Opposite the bores 26a, the board 24a has a passage 27a which is shaped like a truncated cone. A screw 28a can be screwed into each bore 26a, the head of said screw being accommodated in the passage 27a, so that the outside of the housing is flush with the board 23a.

The embodiment of Fig. 2b differs from the embodiment of Fig. 2a in that a plate 29 is fitted on the outside of the board 24b, with passages which are suitable for fully accommodating therein the heads of screws 28b. This is advantageous because the production of a conical passage in a printed circuit board, which is often made of glass-reinforced epoxy resin, is difficult. It is pointed out here that the plate 29 is of a thickness of, for example, only 0.5 mm, and the printed circuit board 23b is approximately 1 mm thick.

In the embodiment of Fig. 2c, edges of the board 24c are accommodated in slots of the side walls of the part 23c. This situation can also be obtained by flanging the edges of said side walls after the board 24c is placed on supporting edges of the main part 23c.

In the embodiment of Fig. 2d, snap elements 30 with resilient legs are fed through passages 27d, and hook-shaped ends of the legs can be slotted behind a projection 31 of the main part 23d.

The embodiment of Fig. 2e, by comparison with the embodiment of Fig. 2d, has snap elements 32 which are fixed, for example glued, on the inside of the board 24e and can slot behind a projection 33 of the main part 23e. In this way a very simple fitting with a flat outside of the housing is obtained. For the removal of the board 24e, passages 34 can be formed in the side walls of the main part 23e, through which passages a pin can be inserted for bending back the legs of the snap elements 32.

Fig. 2f shows a very simple embodiment, in which edges of the board 24f are glued onto a supporting edge of the main part 23f.

It is pointed out that a decorative film, such as the film 9 in Fig. 1, can be placed, for example glued, on the outside of the board 24a to 24f. Unevennesses, for example by conductor tracks, are in this way evened out on the outside of the board 24a to 24f.

## Claims

1. Paging receiver of a paging system, comprising a housing in which a number of electronic components (15, 18, 19, 20) are fitted on a printed circuit board (7, 24) fixed to the housing, **characterized in that** the printed circuit board (24) is provided only at one side with components (15, 18, 19, 20) which are of great heights relative to the thickness of the board (7, 24), and in that the board (7, 24) forms a wall part of the housing, while the side of the board without relatively high components forms a part of the outside of the housing.

2. Paging receiver according to claim 1, **characterized in that** the board (7, 24) forms essentially an entire wall of the housing.

3. Paging receiver according to claim 1, **characterized in that** a decorative finishing layer is provided on the outside of the board.

4. Paging receiver according to claim 1, **characterized in that** a decorative sheet (9) is placed on the outside of the board (7, 24).

5. Paging receiver according to claim 1, **characterized in that** the board (24a) has at least one passage (27a) for allowing through a screw (28a) for fixing the board (24a) to the remainder of the housing, and at the outside the passage (27a) has a wider part for accommodation therein of the head of a screw.

6. Paging receiver according to claim 1, **characterized in that** a plate (29) is fitted against the outside of the board (24b), and the board and the plate (29) each have at least one passage in line with each other, the passage of the plate being suitable for the accommodation therein of the head of a screw (28b) for fixing the board (24b) and the plate (29) to the remainder of the housing.

7. Paging receiver according to claim 1, **characterized in that** the board (24d) has at least one passage (27d) for allowing through a snap element (30) with a hook part and with a head which is wider than the diameter of the passage (27d), and in that a hook component (31) which is complementary to the hook part is provided in the housing for obtaining a snap connection between the hook part and the hook component (31).

8. Paging receiver according to claim 1, **characterized in that** at least one snap element (32) with a hook part is fitted on the inside of the board (24e), and in that a complementary hook component (33) is fitted in the housing for each snap element (32), in order to obtain a snap connection between the hook part and the hook component (33).

9. Paging receiver according to claim 7 or 8, **characterized in that** the housing has at least one other passage (34) for allowing through a tool piece for breaking the snap connection therewith.

10. Paging receiver according to claim 1, **characterized in that** the board (24f) is glued against the remainder of the housing.

## Patentansprüche

1. Funkrufempfänger eines Funkrufsystemes, der ein Gehäuse aufweist, in dem eine Anzahl von elektronischen Komponenten (15, 18, 19, 20) auf einer gedruckten Schaltungskarte (7, 24) eingepaßt sind, die an dem Gehäuse befestigt ist,
dadurch gekennzeichnet, daß
die gedruckte Schaltungskarte (24) nur auf einer Seite mit Komponenten (15, 18, 19, 20) versehen ist, die von großer Höhe im Verhältnis zu der Dicke der Karte (7, 24) sind, und dadurch daß die Karte (7, 24) einen Wandteil des Gehäuses bildet, während die Seite der Karte ohne relativ hohe Komponenten einen Teil der Außenseite des Gehäuses bildet.

2. Funkrufempfänger gemäß Anspruch 1, dadurch gekennzeichnet, daß die Karte (7, 24) im wesentlichen eine vollständige Wand des Gehäuses bildet.

3. Funkrufempfänger gemäß Anspruch 1, dadurch gekennzeichnet, daß eine dekorative abschließende Schicht auf der Außenseite der Karte bereit gestellt ist.

4. Funkrufempfänger gemäß Anspruch 1, dadurch gekennzeichnet, daß ein dekoratives Blatt (9) auf der Außenseite der Karte (7, 24) angeordnet ist.

5. Funkrufempfänger gemäß Anspruch 1, dadurch gekennzeichnet, daß die Karte (24a) zumindest einen Durchgang (27a) hat, um eine Schraube (28a) zum Befestigen der Karte (24a) an dem Rest des Gehäuses durchzulassen, und auf der Außenseite des Durchganges (27a) einen breiteren Teil hat, um darin den Kopf einer Schraube aufzunehmen.

6. Funkrufempfänger gemäß Anspruch 1, dadurch gekennzeichnet, daß eine Platte (29) gegen die Außenseite der Karte (24b) befestigt ist, und daß die Karte und die Platte (29) jeweils zumindest einen Durchgang in einer Linie miteinander haben, wobei der Durchgang der Platte dazu geeignet ist, in sich den Kopf einer Schraube (28b) aufzunehmen, um die Karte (24b) und die Platte (29) an dem Rest des Gehäuses zu befestigen.

7. Funkrufempfänger gemäß Anspruch 1, dadurch gekennzeichnet, daß die Karte (24d) zumindest einen Durchgang (27b) hat, um ein Schnappelement (30) mit einem Hakenteil und einem Kopf durchzulassen, der breiter als der Durchmesser des Durchganges (27d) ist, und dadurch, daß eine Hakenkomponente (31), die komplementär zu dem Hakenteil ist, in dem Gehäuse bereit gestellt ist, um eine Schnappverbindung zwischen dem Hakenteil und der Hakenkomponente (31) zu erhalten.

8. Funkrufempfänger gemäß Anspruch 1, dadurch gekennzeichnet, daß zumindest ein Schnappelement (32) mit einem Hakenteil auf der Innenseite der Karte (24e) befestigt ist, und dadurch, daß eine komplementäre Hakenkomponente (33) in dem Gehäuse für jedes Schnappelement (32) befestigt ist, um eine Schnappverbindung zwischen dem Hakenteil und der Hakenkomponente (33) zu erhalten.

9. Funkrufempfänger gemäß Anspruch 7 oder 8, dadurch gekennzeichnet, daß das Gehäuse zumindest einen anderen Durchgang (34) hat, um dadurch ein Werkzeugteil durchzulassen, um die Schnappverbindung damit aufzubrechen.

10. Funkrufempfänger gemäß Anspruch 1, dadurch gekennzeichnet, daß die Karte (24f) gegen den Rest des Gehäuses geklebt ist.

## Revendications

1. Récepteur d'appel d'un système d'appel, comprenant un boîtier dans lequel un nombre de composants électroniques (15, 18, 19, 20) sont adaptés sur une plaquette à circuits imprimés (7, 24) fixée au boîtier, caractérisé par le fait que la plaquette à circuits imprimés (24) est munie seulement sur un côté de composants (15, 18, 19, 20) qui sont de hauteurs importantes par rapport à l'épaisseur de la plaquette (7, 24), et par le fait que la plaquette (7, 24) forme une partie de paroi du boîtier, alors que le côté de la plaquette sans les composants relativement hauts forme une partie de l'extérieur du boîtier.

2. Récepteur d'appel selon la revendication 1, caractérisé par le fait que la plaquette (7, 24) forme sensiblement une paroi entière du boîtier.

3. Récepteur d'appel selon la revendication 1, caractérisé par le fait qu'une couche de finition décorative est disposée sur l'extérieur de la plaquette.

4. Récepteur d'appel selon la revendication 1, caractérisé par le fait qu'une feuille décorative (9) est placée sur l'extérieur de la plaquette (7, 24).

5. Récepteur d'appel selon la revendication 1, caractérisé par le fait que la plaquette (24a) présente au moins un passage (27a) pour permettre le passage d'une vis (28a) en vue de la fixation de la plaquette (24a) au reste du boîtier, et, à l'extérieur, le passage (27a) présente une partie plus large pour y recevoir la tête d'une vis.

6. Récepteur d'appel selon la revendication 1, caractérisé par le fait qu'une plaque (29) est adaptée contre l'extérieur de la plaquette (24b), et la plaquette et la plaque (29) présentent chacune au moins un passage en alignement réciproque, le passage de la plaque étant approprié pour y recevoir la tête d'une vis (28b) en vue de la fixation de la plaquette (24b) et de la plaque (29) au reste du boîtier.

7. Récepteur d'appel selon la revendication 1, caractérisé par le fait que la plaquette (24d) présente au moins un passage (27d) pour permettre le passage d'un élément d'encliquetage (30) ayant une partie formant crochet et ayant une tête qui est plus large que le diamètre du passage (27d), et par le fait qu'un composant d'accrochage (31), qui est complémentaire de la partie formant crochet, est prévu dans le boîtier pour obtenir une liaison par encliquetage entre la partie formant crochet et le composant d'accrochage (31).

8. Récepteur d'appel selon la revendication 1, caractérisé par le fait qu'au moins un élément d'encliquetage (32) ayant une partie formant crochet est adapté sur l'intérieur de la plaquette (24e), et par le fait qu'un composant d'accrochage complémentaire (33) est adapté dans le boîtier pour chaque élément d'encliquetage (32), afin d'obtenir une liaison par encliquetage entre la partie formant crochet et le composant d'accrochage (33).

9. Récepteur d'appel selon l'une des revendications 7 ou 8, caractérisé par le fait que le boîtier présente au moins un autre passage (34) pour permettre le passage d'un outil destiné à rompre la liaison par encliquetage.

10. Récepteur d'appel selon la revendication 1, caractérisé par le fait que la plaque (24f) est collée contre le reste du boîtier.
